# EUROPEAN PATENT SPECIFICATION

(11) **EP 2 150 959 B1**
(45) Date of publication and mention of the grant of the patent: **28.09.2016**
(21) Application number: 08755718.7
(22) Date of filing: 16.05.2008
(51) Int. Cl.: G11C 7/12, G11C 11/4094

(54) **METHOD AND APPARATUS FOR REDUCING LEAKAGE CURRENT IN MEMORY ARRAYS**
VERFAHREN UND VORRICHTUNG ZUR VERRINGERUNG VON LECKSTROM BEI EINER SPEICHERMATRIX
PROCÉDÉ ET APPAREIL POUR RÉDUIRE LE COURANT DE FUITE DANS DES MATRICES MÉMOIRE

(30) Priority: 18.05.2007 US 750505
(43) Date of publication of application: 10.02.2010
(73) Proprietor: QUALCOMM Incorporated, San Diego, California 92121-1714 (US)
(72) Inventor: JUNG, Chang Ho, San Diego, California 92121-1714 (US); CHEN, Nan, San Diego, California 92121-1714 (US); CHEN, Zhiqin, San Diego, California 92121-1714 (US)
(74) Representative: Tomkins & Co
(86) International application number: PCT/US2008/063916
(87) International publication number: WO 2008/144526

(56) References cited:
- US-A1- 2004 042 325
- US-A1- 2004 145 959
- US-A1- 2004 223 396

## Description

### BACKGROUND

### I. Field

The present disclosure relates generally to electronics, and more specifically to techniques for reducing leakage current in memory arrays.

### II. Background

Integrated circuit (IC) fabrication technology continually improves and, as a result, the size of transistors continues to shrink. This enables more transistors and more complicated circuits to be fabricated on an IC die or, alternatively, a smaller die to be used for a given circuit. Smaller transistor size also supports faster operating speed and provides other benefits.

For complementary metal oxide semiconductor (CMOS) technology, which is widely used for digital circuits and some analog circuits, a major issue with shrinking transistor size is leakage current. Smaller transistor geometry results in higher electric field (E-field), which stresses a transistor and causes oxide breakdown. To decrease the E-field, a lower power supply voltage is often used for smaller geometry transistors. Unfortunately, the lower power supply voltage also increases the delay of the transistors, which is undesirable for high-speed circuits. To reduce the delay and improve operating speed, the threshold voltage (Vt) of the transistors is reduced. The threshold voltage is the voltage at which the transistors, turn on. However, the lower threshold voltage and smaller transistor geometry result in higher leakage current, which is the current passing through a transistor when it is turned off.

Leakage current is more problematic as CMOS technology scales smaller. This is because leakage current increases at a high rate with respect to the decrease in transistor size. Furthermore, leakage current is a major issue for portable devices such as cellular phones, personal digital assistants (PDAs), laptop computers, etc. Leakage current consumes battery power and reduces standby time for portable devices that use batteries.

Reducing leakage current without sacrificing too much performance is a major challenge in CMOS designs, especially as IC technology scales smaller. Leakage current reduction is especially challenging for memory arrays, which are commonly used in many electronics devices. A memory array has many rows and many columns of memory cells to store data and may have many leakage current paths. Each leakage current path should be addressed in order to achieve low leakage current for the memory array.

US2004223396 disclsoes a dynamic semiconductor memory device capable of reducing standby current. In a standby mode wherein only a refresh operation is performed, a precharge/equalize signal is activated only during a predetermined period before a word line is activated so as to precharge a bit line pair to a voltage that is half a line voltage immediately before the word line is activated. In the standby mode, the bit line pair is electrically isolated from a regulator that generates a voltage that is half the line voltage except for the above predetermined period, thus preventing leakage current from flowing therebetween even if a defect in which the word line is shorted with the bit lines occurs.

In US2004145959 data indicating whether a short-circuit defect exists in a memory block is programmed a fuse program circuit. In accordance with the fuse program data and a mode instruction signal, the correspondence relationship between a block select signal and a corresponding bit line isolation instruction signal is switched by a circuit that generates the bit line isolation instruction signal in a specific mode. It becomes possible to isolate the memory block in which a leakage current path exists from a corresponding sense amplifier band in a specific operation mode. Current consumption at least at a standby state is reduced.

In US2004042325 against which the preamble is based on, plurality of p-MOSFETs connected to a power supply line is turned on to precharge bit lines. A precharge cancel signal generated by a NOR circuit and an inverter performs precharge control to turn off the p-MOSFETs to set the bit lines in a floating state during the period of a standby mode, or turn on the p-MOSFETs to precharge the bit lines during the period of a read mode or write mode.

### SUMMARY

Techniques for reducing leakage current in memory arrays are described herein. A memory array comprises multiple rows and multiple columns of memory cells. Bit lines are coupled to the columns of memory cells, and word lines are coupled to the rows of memory cells. The bit lines have disconnected paths to a power supply and float during a sleep mode for the memory array. The bit lines may be floated by turning off all transistors coupled between the power supply and the bit lines.

The bit lines may be coupled to (i) precharge circuits used to precharge the bit lines to logic high prior to each read or write operation, (ii) pass transistors used to couple the bit lines to sense amplifiers for read operations, and (iii) pull-up transistors in drivers used to drive the bit lines for write operations. The precharge circuits, pass transistors, and pull-up transistors may all be turned off during the sleep mode. The word lines may be set to a predetermined logic level to disconnect the memory cells from the bit lines during the sleep mode. The memory cells may be disconnected from the power supply via at least one head switch during the sleep mode, e.g., if data retention by the memory cells is not needed.

Various aspects and features of the disclosure are described in further detail below.

### BRIEF DESCRIPTION OF THE DRAWINGS

FIG. 1 shows a block diagram of a memory device.
FIGS. 2 and 3 show schematic diagrams of two designs of a memory array and an input/output (I/O) circuit.
FIG. 4 shows a schematic diagram of a word line driver.
FIG. 5 shows a process for placing a memory array in a sleep mode.
FIG. 6 shows a block diagram of a wireless device.

### DETAILED DESCRIPTION

Techniques for reducing leakage current in memory arrays are described herein. The memory arrays may be for random access memory (RAM), static RAM (SRAM), dynamic RAM (DRAM), synchronous DRAM (SDRAM), video RAM (VRAM), synchronous graphic RAM (SGRAM), read only memory (ROM), Flash memory, etc. The memory arrays may be part of stand-alone memory devices or may be embedded within other devices, e.g., processors.

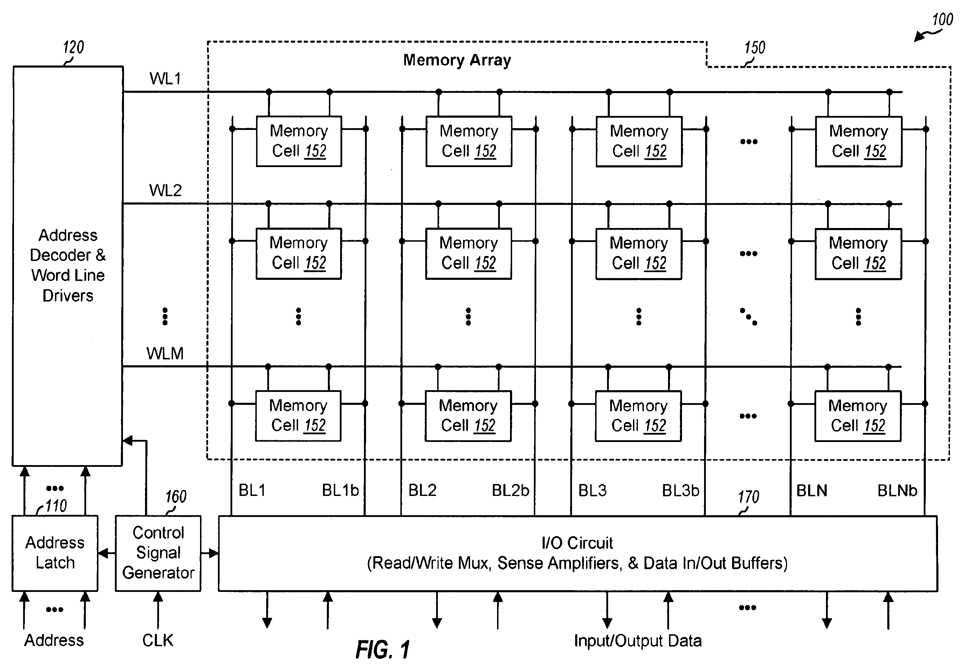

FIG. 1 shows a block diagram of a design of a memory device 100 with low leakage current. Memory device 100 includes an address latch 110, an address decoder and word line drivers 120, a memory array 150, a control signal generator 160, and an I/O circuit 170. Memory array 150 is also referred to as a core array.

Memory array 150 includes M rows and N columns of memory cells 152, where M and N may each be any value. A memory cell is a circuit that can store a data value and may be implemented with various circuit designs. The M rows of memory cells are selected via M word lines WL1 through WLM. The N columns of memory cells arc coupled to N differential bit lines BL1 and BL1b through BLN and BLNb.

Address latch 110 receives an address for a memory cell or a block of memory cells to be accessed and latches the address. Address decoder 120 receives the latched address and may generate a row address based on the received address. Address decoder 120 may then perform pre-decoding on the row address and provide pre-decoded signals that indicate a specific word line to activate or assert. Word line drivers 120 receive the pre-decoded signals and drive a specific word line, as indicated by the pre-decoded signals, so that the desired row of memory cells can be accessed.

I/O circuit 170 includes various circuits for reading data from memory cells 152 and writing data to the memory cells. For example, I/O circuit 170 includes a sense amplifier and a data output buffer for each differential bit line to read data from the memory cells coupled to that bit line. I/O circuit 170 further includes a data latch and data input drivers for cach differential bit line to write data to the memory cells coupled to that bit line.

Control signal generator 160 receives an external clock signal CLK and generates control signals used to control the operation of memory device 100. For example, generator 160 may generate control signals used for read and write operations.

Memory device 100 may be fabricated with a deep sub-micron CMOS process. Leakage current for memory device 100 may come from the following sources:
- Memory array 150 - include memory cells and bit lines, and
- Peripheral circuits - include circuits other than memory array 150, e.g., control signal generator 160, I/O circuit 170, etc.

Leakage current via the peripheral circuits may be mitigated in several manners. In one design, the peripheral circuits may be implemented with both (i) low-Vt transistors for sections where high performance is desired and (ii) high-Vt transistors for sections where low leakage current is desired and high performance is not needed. In another design, low-Vt transistors may be used for the peripheral circuits and high-Vt transistors may be used as foot switches to connect or disconnect the peripheral circuits to circuit ground. In a functional/operational mode, the foot switches may be turned on, and the peripheral circuits may operate in the normal manner. In a sleep mode, the foot switches may be turned off, and leakage current through the peripheral circuits may be limited by the leakage current through the foot switches. High-Vt transistors may be used for the foot switches to reduce leakage current via the peripheral circuits.

Leakage current via memory array 150 may also be mitigated in several manners. First, the power supply to the memory cells may be disconnected with head switches during the sleep mode, which may reduce leakage current through the memory cells. Second, leakage current through the memory cells via the bit lines may be reduced by floating the bit lines during the sleep mode, as described below.

In general, a head switch and/or a foot switch may be used for a given circuit to reduce leakage current. It may be desirable to use head switches for memory array 150 to improve performance. Pull-down strength is an important factor for read/write performance. Adding foot switches in series with pull-down transistors within the memory cells may affect pull-down strength and impact performance. Head switches may be used for the memory array in order to minimize impact to pull-down strength. It may be desirable to use foot switches for peripheral circuits since foot switches may be implemented with less IC die area than head switches. In general, head switches or foot switches or both may be used for memory array 150. Head switches or foot switches or both may also be used for peripheral circuits. For clarity, the following description assumes that head switches are used for memory array 150 and foot switches are used for peripheral circuits.

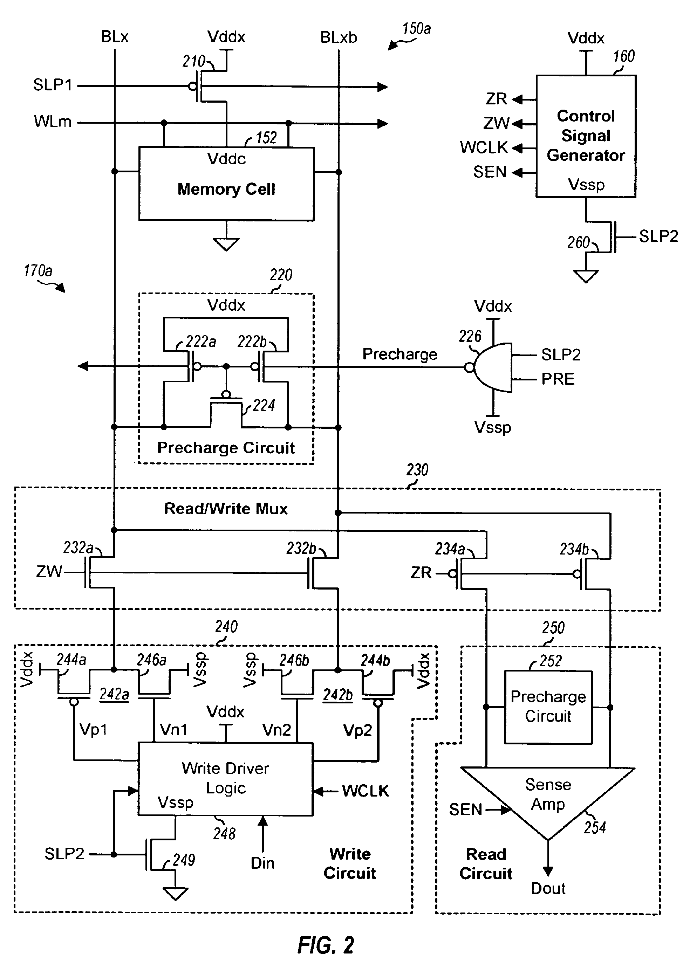

**FIG. 2** shows a schematic diagram of a memory array 150a and an I/O circuit 170a, which is one design of memory array 150 and I/O circuit 170, respectively, in FIG. 1. For clarity, only one memory cell 152, one word line WLm, and one differential bit line BLx and BLxb are shown in FIG. 2, where m ∈ {1, ..., M} and x ∈ {1,..., N}. Also for clarity, read/write circuits for only one bit line is shown in FIG. 2.

In the design shown in FIG. 2, a P-channel field effect transistor (P-FET) 210 is used as a head switch for memory cell 152. P-FET 210 has its gate receiving a sleep signal SLP1, its drain coupled to a power supply Vddx, and its source providing a supply voltage Vddc to memory cell 152. The SLP1 signal is at logic low when memory device 100 is in the functional mode. In the sleep mode, the SLP1 signal may be set to logic low to retain the data stored in memory cell 152 or to logic high to reduce leakage current through memory cell 152. P-FET 210 may thus be turned on during the functional mode and may be turned on or off during the sleep mode depending on whether or not data retention by memory cell 152 is desired. In general, memory array 150a may include any number of head switches, e.g., one head switch for the entire memory array, one head switch for each column of memory cells, one head switch for each row of memory cells, one head switch for each memory cell, one head switch for each group of memory cells, etc. The head switches may be implemented with high-Vt transistors to achieve low leakage current.

In the design shown in FIG. 2, for each bit line, I/O circuit 170a includes a precharges circuit 220, a read/write multiplexer (Mux) 230, a write circuit 240, and a read circuit 250. Precharge circuit 220 precharges lines BLx and BLxb to logic high prior to each read and write operation. Multiplexer 230 couples lines BLx and BLxb to write circuit 240 for write operations and to read circuit 250 for read operations. For a write operation, write circuit 240 drives lines BLx and BLxb to write an input data value Din to a selected memory cell 152. For a read operation, read circuit 250 amplifies the voltage difference between lines BLx and BLxb, which are driven by a selected memory cell. Read circuit 250 then detects a logic value (e.g., either low or high) for the amplified voltage and provides the detected logic value.

Precharge circuit 220 includes two precharge P-FETs 222a and 222b for lines BLx and BLxb, respectively, and an equalization P-FET 224. P-FETs 222a and 222b have their gates coupled together and to a Precharge signal, their sources coupled to the Vddx power supply, and their drains coupled to lines BLx and BLxb, respectively. P-FET 224 has its gate coupled to the Precharge signal, its source coupled to line BLx, and its drain coupled to line BLxb. One line (either BLx or BLxb) is at logic low and the other line (either BLxb or BLx) is at logic high prior to a precharge operation. P-FET 224 connects lines BLx and BLxb together during the precharge operation and allows both P-FETs 222a and 222b to pull up the line that is at logic low toward logic high.

Multiplexer 230 includes N-FETs 232a and 232b and P-FETs 234a and 234b. N-FETs 232a and 232b have their gates coupled together and to a write signal ZW, their drains coupled to lines BLx and BLxb, respectively, and their sources coupled to write circuit 240. P-FETs 234a and 234b have their gates coupled together and to a read signal ZR, their sources coupled to lines BLx and BLxb, respectively, and their drains coupled to read circuit 250.

For a write operation, the ZW signal is at logic high for certain duration, and N-FETs 232a and 232b are turned on and couple lines BLx and BLxb to write circuit 240. The ZR signal is at logic high for the entire write operation, and P-FETs 234a and 234b arc turned off and isolate read circuit 250 from lines BLx and BLxb. Lines BLx and BLxb are initially precharged to logic high, and either line BLx or BLxb is thereafter pulled to logic low to write to memory cell 152. N-FETs 232a and 232b are better at passing logic low/ zero than P-FETs.

For a read operation, the ZR signal is at logic low for certain duration, and P-FETs 234a and 234b are turned on and couple lines BLx and BLxb to read circuit 250. The ZW signal is at logic low for the entire read operation, and N-FETs 232a and 232b are turned off and isolate write circuit 240 from lines BLx and BLxb. Lines BLx and BLxb are initially precharged to the same high voltage and are thereafter pulled apart by the selected memory cell 152. P-FETs 234a and 234b are better at passing high voltage or logic one on either line BLx or BLxb than N-FETs.

Write circuit 240 includes drivers 242a and 242b for lines BLx and BLxb, respectively, write driver logic 248, and an N-FET 249 that is used as a foot switch. Each driver 242 includes a P-FET 244 coupled in a stacked configuration with an N-FET 246. N-FET 246a has its source coupled to a virtual ground Vssp, its gate receiving a control signal Vn1 from logic 248, and its drain coupled to the drain of P-FET 244a. P-FET 244a has its gate receiving a control signal Vp1 from logic 248 and its source coupled to the Vddx power supply. FETs 244b and 246b are coupled in the same manner as FETs 244a and 244b and receive control signals Vp2 and Vn2, respectively, from logic 248. The drains of FETs 244a and 246a are coupled to line BLx, and the drains of FETs 244b and 246b are coupled to line BLxb. N-FET 249 has its source coupled to circuit ground, its gate receiving an SLP2 signal, and its drain providing virtual ground Vssp. The SLP2 signal is at logic high during the functional mode and at logic low during the sleep mode, which is opposite of the SLP1 signal. N-FET 249 may be implemented with a high-Vt transistor to achieve low leakage current. Logic 248 receives the Din data and the SLP2 signal and generates the Vp1 and Vn1 signals for FETs 244a and 246a, respectively, and the Vp2 and Vn2 signals for FETs 244b and 246b, respectively.

Read circuit 250 includes a precharge circuit 252 and a sense amplifier (Amp) 254. Precharge circuit 252 precharges the inputs of sense amplifier 254 to logic high prior to each read operation. Precharge circuit 252 may be implemented with three P-FETs coupled in the same manner as precharge circuit 220. Sense amplifier 254 senses the voltage difference between lines BLx and BLxb and provides the detected logic value.

Control signal generator 160 may be coupled to a foot switch implemented with an N-FET 260. N-FET 260 has its source coupled to circuit ground, its gate receiving the SLP2 signal, and its drain providing virtual ground Vssp for generator 160. Generator 160 may generate various control signals such as the ZW signal for N-FETs 232a and 232b, the ZR signal for P-FETs 234a and 234b, a data input driver clock (WCLK) signal used for write operations, and a sense amplifier enable (SEN) signal used for read operations.

Control signal generator 160 may be turned on or off via the foot switch implemented with N-FET 260. During the sleep mode, N-FET 260 may be turned off, the virtual ground Vssp may float between the Vddx power supply and circuit ground, and the control signals from generator 160 may slowly rise toward the Vddx power supply. Consequently, circuits that rely on their control signals being at logic low to turn off may not receive the logic low during the sleep mode. For example, N-FETs 232a and 232b rely on the ZW signal being at logic low to turn off. Since the ZW signal may float between Vddx and circuit ground during the sleep mode, N-FETs 232a and 232b may float during the sleep mode.

As shown in FIG. 2, head switches may be used for memory cells 152 in memory array 150. Foot switches may be used for peripheral circuits such as write circuit 240, control signal generator 160, etc.

As also shown in FIG. 2, there may be several leakage current paths through memory cell 152 via bit lines BLx and BLxb. A first leakage current path may be from precharge circuit 220 via the bit lines and through memory cell 152. A second leakage current path may be from drivers 242a and 242b via the bit lines and through memory cell 152. A third leakage current path may be from precharge circuit 252 via the bit lines and through memory cell 152. All of these leakage current paths may be disconnected by floating the bit lines during the sleep mode.

Table 1 lists actions to perform to float bit lines BLx and BLxb, for the design shown in FIG. 2.

**Table I**

| **Action** | **Control Signal Setting** |
|---|---|
| Turn off precharge circuit 220 | Set Precharge signal to logic high |
| Turn off P-FETs 234a and 234b in multiplexer 230 | Set ZR signal to logic high |
| Turn offP-FETs 244a and 244b in write circuit 240 | Set Vp1 and Vp2 signals to logic high |

During the functional mode, P-FETs 222a, 222b and 224 within precharge circuit 220 are turned on prior to each read or write operation to precharge bit lines BLx and BLxb to logic high. A NAND gate 226 receives a PRE signal and the SLP2 signal and generates the Precharge signal for P-FETs 222a, 222b and 224. The PRE signal is at logic low for each read or write operation and is at logic high at other times. During the functional mode, the SLP2 signal is at logic high, and the Precharge signal is an inverted version of the PRE signal. During the sleep mode, the SLP2 signal is at logic low, the Precharge signal is at logic high, and P-FETs 222a, 222b and 224 are turned off by the logic high on the Precharge signal. Precharge circuit 220 is thus turned off by the Precharge signal during the sleep mode.

During the functional mode, P-FETs 234a and 234b within multiplexer 230 may be turned on for read operations and turned off for write operations. During the sleep mode, P-FETs 234a and 234b may be turned off by applying logic high on the ZR signal. Generator 160 may be able to generate logic high on the ZR signal, even when N-FET 260 is turned off in the sleep mode, since the Vddx power supply is available to generator 160. Since N-FETs 234a and 234b can be turned off during the sleep mode, it may not be necessary to turn off precharge circuit 252. Nevertheless, precharge circuit 252 may be turned off during the sleep mode to further reduce leakage current.

During the functional mode, N-FETs 232a and 232b within multiplexer 230 may be turned on for write operations and turned off for read operations. P-FETs 244a and 244b within write circuit 240 may be turned on during a precharge phase of a write cycle to pull lines BLx and BLxb to logic high. During a write phase of the write cycle, driver 242a drives line BLx to logic low or high depending on the Din value, and driver 242b drives line BLxb to logic high or low depending on the Din value. During the sleep mode, N-FETs 232a and 232b may float because logic low is not achievable for the ZW signal with N-FET 260 turned off. P-FETs 244a and 244b within write circuit 240 may be turned off during the sleep mode to ensure no leakage current path from drivers 242a and 242b via bit lines BLx and BLxb through memory cell 152. Logic 248 may be able to generate logic high on the Vp1 and Vp2 signals for P-FETs 244a and 244b, respectively, even when N-FET 249 is turned off in the sleep mode, since the Vddx power supply is available to logic 248.

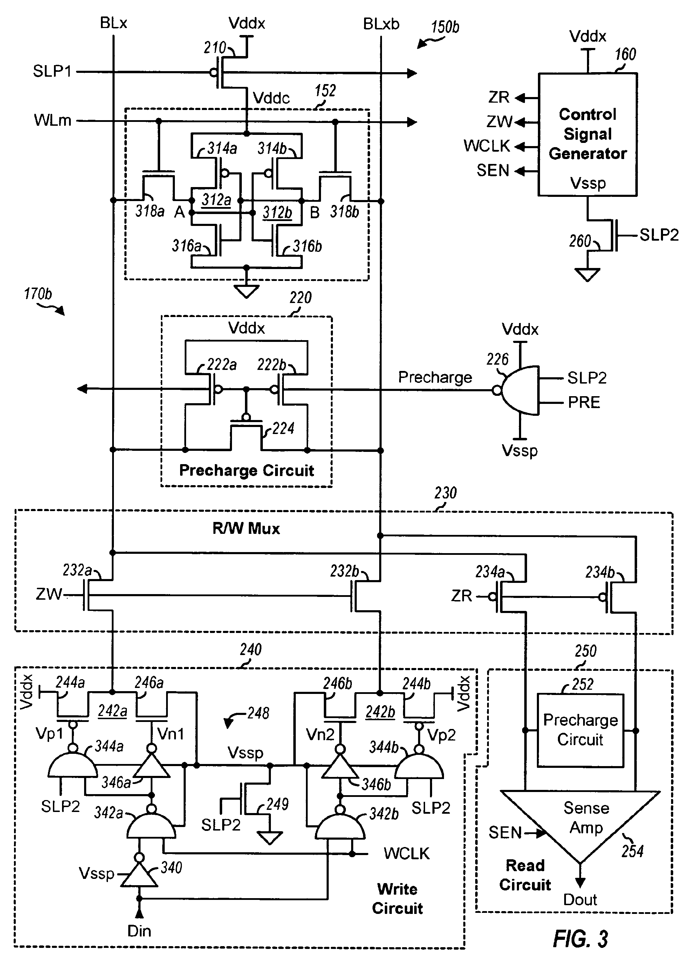

**FIG. 3** shows a schematic diagram of a memory array 150b and an I/O circuit 170b, which is another design of memory array 150 and I/O circuit 170, respectively, in FIG. 1. For clarity, only one memory cell 152, one word line WLm, one differential bit line BLx and BLxb, and read/write circuits for one bit line are shown in FIG. 3.

In the design shown in FIG. 3, P-FET 210 is used as a head switch for memory cell 152. Memory cell 152 includes a pair of cross-coupled inverters 312a and 312b and a pair of N-FETs 318a and 318b that are used as pass transistors. Each inverter 312 is formed with a P-FET 314 and an N-FET 316. N-FET 316 has is source coupled to circuit ground, its gate coupled to the gate of P-FET 314, and it drain coupled to the drain of P-FET 314. P-FET 314 has its source coupled to the Vddc supply voltage. Inverter 312a has its output coupled to node A and its input coupled to node B. Inverter 312b has its output coupled to node B and its input coupled to node A. N-FET 318a has its drain coupled to node A, its gate coupled to word line WLm, and its source coupled to line BLx. N-FET 318b has its drain coupled to node B, its gate coupled to word line WLm, and its source coupled to line BLxb.

Inverters 312a and 312b store a data value via positive feedback. If memory cell 152 stores logic high ('1'), node A is at logic high and node B is at logic low. If memory cell 152 stores logic low ('0'), node A is at logic low and node B is at logic high. For a memory read, lines BLx and BLxb are initially precharged to logic high by precharge circuit 220, then word line WLm is asserted to logic high, and N-FETs 318a and 318b are turned on. If memory cell 152 stores logic high, then line BLx is charged by inverter 312a via N-FET 318a, and line BLxb is discharged by inverter 312b via N-FET 318b. The converse is true if memory cell 152 stores logic low.

For a memory write, lines BLx and BLxb are initially precharged to logic high by precharge circuit 220, then word line WLm is asserted to logic high, and N-FETs 318a and 318b are turned on. To write logic high ('1') to memory cell 152, line BLx is driven high and forces node A to logic high via N-FET 318a, and line BLxb is driven low and forces node B to logic low via N-FET 318b. The converse is true when writing logic low to memory cell 152.

During the sleep mode. P-FET 210 may be turned off, and the Vddc supply voltage may then drop to an intermediate voltage determined by the leakage current through P-FET 210 and the leakage current through all memory cells coupled to P-FET 210. Inverters 312a and 312b may be isolated from bit lines BLx and BLxb by bringing word line WLm to logic low, which would then turn off N-FETs 318a and 318b.

I/O circuit 170b includes precharge circuit 220, multiplexer 230, write circuit 240, and read circuit 250 for each bit line. Write circuit 240 includes drivers 242a and 242b for lines BLx and BLxb, respectively, write driver logic 248, and N-FET 249. Within logic 248, an inverter 340 receives the Din data and provides an inverted Din. A NAND gate 342a receives the output of inverter 340 and the WCLK signal at two inputs and provides a latched Din. A NAND gate 342b receives the Din data and the WCLK signal at two inputs and provides a latched inverted Din. A NAND gate 344a receives the output of NAND gate 342a and the SLP2 signal at two inputs and provides the Vp1 signal for P-FET 244a. An inverter 346a receives the output of NAND gate 342a and provides the Vn1 signal for N-FET 246a. A NAND gate 344b receives the output of NAND gate 342b and the SLP2 signal at two inputs and provides the Vp2 signal for P-FET 244b. An inverter 346b receives the output of NAND gate 342b and provides the Vn2 signal for N-FET 246b.

During the functional mode, the SLP2 signal is at logic high, NAND gate 342a provides the latched Din, NAND gate 344a turns on P-FET 244a to pull up line BLx if Din is logic high, and inverter 346a turned on N-FET 246a to pull down line BLx if Din is logic low. NAND gate 342b provides the latched inverted Din, NAND gate 344b turns on P-FET 244b to pull up line BLxb if Din is logic low, and inverter 346b turned on N-FET 246b to pull down line BLxb if Din is logic high. During the sleep mode, the SLP2 signal is at logic low, the Vp1 signal from NAND gate 344a is at logic high, and P-FET 244a is turned off. The Vp2 signal from NAND gate 344b is also at logic high, and P-FET 244b is also turned off. NAND gates 344a and 344b thus turn off P-FETs 244a and 244b during the sleep mode and enable P-FETs 244a and 244b to be turned on or off during the functional mode. N-FETs 246a and 246b, inverters 340, 346a and 346b, and NAND gates 342a, 342b, 344a and 344b are all coupled to virtual ground Vssp from N-FET 249 and thus float during the sleep mode.

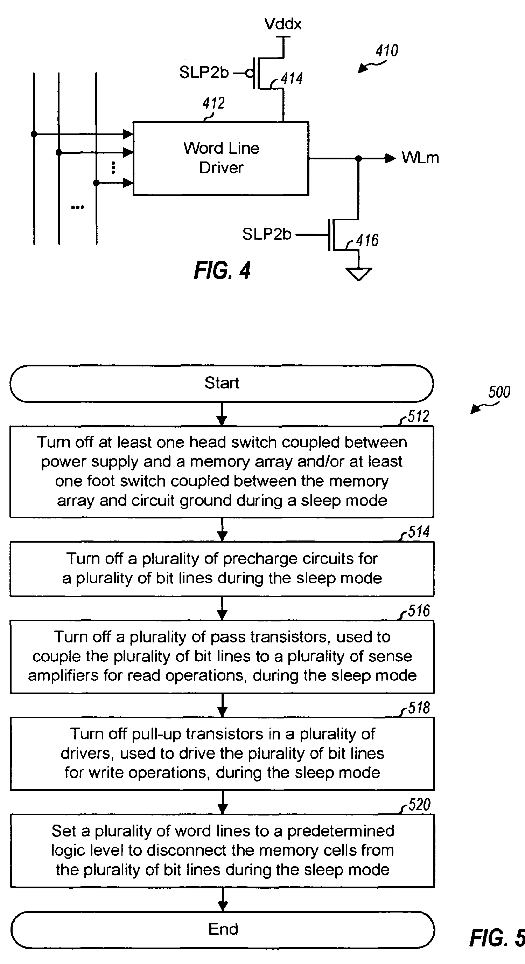

**FIG. 4** shows a schematic diagram of a design of a driver circuit 410 within word line drivers 120 in FIG. 1. Driver circuit 410 drives word line WLm in FIGS. 2 and 3. Within driver circuit 410, a word line driver 412 receives pre-decoded signals and drives word line WLm when selected by the pre-decoded signals. A P-FET 414 implements a head switch for word line driver 412. Word line driver 412 may include multiple stages, foot switches may be used for all stages except for the final/output stage, and a head switch may be used for the final/output stage. An N-FET 416 implements a pull-down transistor and has its source coupled to circuit ground, its gate receiving an SLP2b signal, and its drain coupled to word line WLm. The SLP2b signal is an inverted version of the SLP2 signal. During the functional mode, the SLP2b signal is at logic low, head switch P-FET 414 is turned on, and pull-down N-FET 416 is turned off. During the sleep mode, the SLP2b signal is at logic high, head switch P-FET 414 is turned off, and pull-down N-FET 416 is turned on and pulls word line WLm to logic low.

FIGS. 2, 3 and 4 show specific designs of various blocks within memory device 100. In one design, head switches and/or foot switches may be used for memory array 150 to reduce leakage current during the sleep mode. In this design, the memory cells in memory array 150 may be implemented with low-Vt transistors to achieve high performance, and the head switches and/or foot switches may be used to reduce leakage current. In another design, memory array 150 may be coupled directly between the Vddx power supply and circuit ground, without using head switches or foot switches. In this design, the memory cells in memory array 150 may be implemented with high-Vt transistors to reduce leakage current. In both designs, the word lines may be maintained at logic low during sleep mode in order to reduce leakage current through the memory cells during the sleep mode.

In one design, precharge circuit 220 may be coupled to the Vddx power supply directly, e.g., as shown in FIGS. 2 and 3. In this design, P-FETs 222a, 222b and 224 within precharge circuit 220 may be turned off during the sleep mode by applying logic high on the Precharge signal. In another design, precharge circuit 220 may be coupled to the Vddx power supply via a head switch, which may be implemented in the same manner as P-FET 210. In this design, the head switch for precharge circuit 220 may be turned off during the sleep mode, and the Precharge signal may be at any logic level.

In one design, N-FETs 234a and 234b within multiplexer 230 are turned off during the sleep mode, as described above. In another design, precharge circuit 252 may be turned off during the sleep mode, e.g., in the same manner as precharge circuit 220.

The FETs that are turned off during the sleep mode (e.g., P-FETs 222a, 222b and 224 within precharge circuit 220, P-FETs 234a and 234 within multiplexer 230, and P-FETs 244a and 244b within write circuit 240) may be implemented in a manner to reduce leakage current. For example, these FETs may be implemented with high-Vt transistors if fast operating speed is not required. Alternatively or additionally, these FETs may be implemented with longer lengths to reduce leakage current.

**FIG. 5** shows a design of a process 500 for placing a memory array in a sleep mode. The memory array comprises a plurality of rows and a plurality of columns of memory cells. A plurality of bit lines are coupled to the plurality of columns of memory cells, and a plurality of word lines are coupled to the plurality of rows of memory cells. The bit lines have disconnected paths to a power supply and float during a sleep mode for the memory array. This may be achieved by turning off all transistors coupled between the power supply and the bit lines during the sleep mode.

At least one head switch coupled between the power supply and the memory array and/or at least one foot switch coupled between the memory array and circuit ground may be turned off during the sleep mode (block 512). A plurality of precharge circuits for the plurality of bit lines may be turned off during the sleep mode (block 514). A plurality of pass transistors (e.g., P-FETs 234a and 234b) used to couple the plurality of bit lines to a plurality of sense amplifiers for read operations may be turned off during the sleep mode (block 516). Pull-up transistors (e.g., P-FETs 244a and 244b) in a plurality of drivers, which are used to drive the plurality of bit lines for write operations, may also be turned off during the sleep mode (block 518). The word lines may be set to a predetermined logic level (e.g., logic low) to disconnect the memory cells from the plurality of bit lines during the sleep mode (block 520).

One or more control circuits or logics (e.g., generator 160, NAND gate 226, and logic 248) may be used to generate control signals for the precharge circuits, the pass transistors for read operations, and the pull-up transistors for write operations. The control circuits or logics may be coupled to circuit ground via one or more foot switches and may provide logic high for the control signals during the sleep mode.

The techniques and memory arrays described herein may be used for various applications such as wireless communication, computing, networking, personal electronics, etc. The memory arrays may be implemented in stand-alone memory devices or embedded within processors, digital signal processors (DSPs), reduced instruction set computer (RISC) processors, advanced RISC machine (ARM) processors, graphics processors, graphics processing units (GPUs), controllers, microprocessors, etc. An exemplary use of the memory arrays for a wireless communication device is described below.

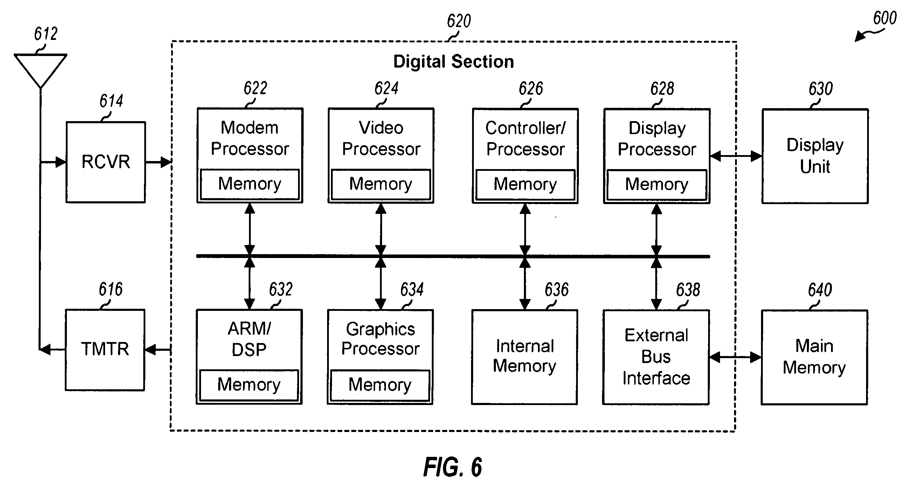

**FIG. 6** shows a block diagram of a wireless device 600 in a wireless communication system. Wireless device 600 may be a cellular phone, a terminal, a handset, a PDA, a wireless modem, etc. The wireless communication system may be a Code Division Multiple Access (CDMA) system, a Global System for Mobile Communications (GSM) system, etc.

Wireless device 600 is capable of providing bi-directional communication via a receive path and a transmit path. On the receive path, signals transmitted by base stations arc received by an antenna 612 and provided to a receiver (RCVR) 614. Receiver 614 conditions and digitizes the received signal and provides samples to a digital section 620 for further processing. On the transmit path, a transmitter (TMTR) 616 receives data to be transmitted from digital section 620, processes and conditions the data, and generates a modulated signal, which is transmitted via antenna 612 to the base stations.

Digital section 620 includes various processing, interface, and memory units such as, for example, a modem processor 622, a video processor 624, a controller/ processor 626, a display processor 628, an ARM/DSP 632, a graphics processor 634, an internal memory 636, and an external bus interface (EBI) 638. Modem processor 622 performs processing for data transmission and reception, e.g., encoding, modulation, demodulation, and decoding. Video processor 624 performs processing on video content (e.g., still images, moving videos, and moving texts) for video applications such as camcorder, video playback, and video conferencing. Controller/processor 626 may direct the operation of various units within digital section 620. Display processor 628 performs processing to facilitate the display of videos, graphics, and texts on a display unit 630. ARM/DSP 632 may perform various types of processing for wireless device 600. Graphics processor 634 performs graphics processing, e.g., for graphics, video games, etc. Internal memory 636 stores data and/or instructions for various units within digital section 620. EBI 638 facilitates transfer of data between digital section 620 (e.g., internal memory 636) and a main memory 640.

Each of processors 622 through 634 may include an embedded memory, which may be implemented as described above. Internal memory 636 and main memory 640 may also be implemented as described above. Digital section 620 may be implemented with one or more application specific integrated circuits (ASICs) and/or some other type of ICs.

The techniques and memory arrays described herein may be implemented in various hardware units such as a memory IC, an ASIC, a DSP, a digital signal processing device (DSPD), a programmable logic device (PLD), a field programmable gate array (FPGA), a controller, a processor, and other electronic devices. The hardware units may be fabricated in various IC process technologies such as CMOS, N-MOS, P-MOS, bipolar-CMOS (Bi-CMOS), bipolar, etc. CMOS technology can fabricate both N-FETs and P-FETs on the same IC die, whereas N-MOS technology can only fabricate N-FETs and P-MOS technology can only fabricate P-FETs. The hardware units may be fabricated with any device size technology, e.g., 130 nanometer (nm), 90 nm, 65 nm, 30 nm, etc.

An apparatus implementing the techniques described herein may be a stand-alone unit or may be part of a device. The device may be (i) a stand-alone IC, (ii) a set of one or more ICs that may include memory ICs for storing data and/or instructions, (iii) an ASIC such as a mobile station modem (MSM), (iv) a module that may be embedded within other devices, (v) a cellular phone, wireless device, handset, or mobile unit, (vi) etc.

The previous description of the disclosure is provided to enable any person skilled in the art to make or use the disclosure. Various modifications to the disclosure will be readily apparent to those skilled in the art, and the generic principles defined herein may be applied to other variations without departing from the scope of the disclosure. Thus, the disclosure is not intended to be limited to the examples and designs described herein but is to be accorded the widest scope consistent with the principles and novel features disclosed herein.

## Claims

1. An integrated circuit comprising:
a memory array (150) comprising a plurality of rows and a plurality of columns of memory cells (152);
a plurality of bit lines coupled to the plurality of columns of memory cells, the bit lines having disconnected paths to a power supply during a sleep mode for the memory array; and **characterised by**:
at least one head switch (210) coupled between the power supply and the memory array, the at least one head switch during the sleep mode being turned on or off depending on wether or not data retention by the memory cells (152) is desired.

2. The integrated circuit of claim 1, further comprising:
a plurality of precharge circuits (220) for the plurality of bit lines, the precharge circuits being turned off during the sleep mode.

3. The integrated circuit of claim 2, further comprising:
a control circuit configured to generate a precharge signal for the plurality of precharge circuits, the control circuit being coupled to circuit ground via a foot switch and providing logic high for the precharge signal during the sleep mode.

4. The integrated circuit of claim 1, further comprising:
a plurality of transistors (234a, 234b) for coupling the plurality of bit lines to a plurality of sense amplifiers (254) for read operations, the plurality of transistors being turned off during the sleep mode.

5. The integrated circuit of claim 4, further comprising:
a control signal generator (160) configured to generate a control signal for the plurality of transistors, the control signal generator being coupled to circuit ground via a foot switch (260) and providing logic high for the control signal during the sleep mode.

6. The integrated circuit of claim 1, further comprising:
a plurality of drivers for driving the plurality of bit lines for write operations, the drivers having pull-up transistors that are turned off during the sleep mode.

7. The integrated circuit of claim 6, further comprising:
a control logic configured to generate control signals for the pull-up transistors in the plurality of drivers, the control logic being coupled to circuit ground via a foot switch and providing logic high for the control signals during the sleep mode.

8. The integrated circuit of claim 1, further comprising:
a plurality of word lines coupled to the plurality of rows of memory cells, the word lines configured to disconnect the memory cells from the plurality of bit lines during the sleep mode.

9. The integrated circuit of claim 8, further comprising:
a driver circuit configured to set the plurality of word lines at a predetermined logic level during the sleep mode to disconnect the memory cells from the plurality of bit lines.

10. The integrated circuit of claim 1, further comprising:
a plurality of transistors coupled between the power supply and the plurality of bit lines, the transistors being turned off during the sleep mode to disconnect the bit lines from the power supply.

11. The integrated circuit of claim 10, wherein the plurality of transistors are implemented with longer lengths than transistors in the memory cells to reduce leakage current when turned off during the sleep mode.

12. A method comprising:
reading data from a plurality of columns of memory cells via a plurality of bit lines during a functional mode;
writing data to the plurality of columns of memory cells via the plurality of bit lines during the functional mode; and **characterised by**:
disconnecting the plurality of bit lines from a power supply during a sleep mode by turning on or off at least one head switch coupled between the power supply and the memory cells during the sleep mode, where the turning on or off depends on wether or not data retention by the memory cells is desired.

13. The method of claim 12, wherein the disconnecting the plurality of bit lines comprises:
turning off a plurality of precharge circuits for the plurality of bit lines during the sleep mode; or
turning off a plurality of transistors, used to couple the plurality of bit lines to a plurality of sense amplifiers for read operations, during the sleep mode; or
turning off pull-up transistors in a plurality of drivers, used to drive the plurality of bit lines for write operations, during the sleep mode.

## Patentansprüche

1. Eine integrierte Schaltung, die Folgendes aufweist:
eine Speicheranordnung (150), die eine Vielzahl von Zeilen und eine Vielzahl von Spalten von Speicherzellen (152) aufweist;
eine Vielzahl von Bitleitungen, die an die Vielzahl von Spalten von Speicherzellen gekoppelt sind, wobei die Bitleitungen nicht verbundene bzw. getrennte Pfade zu einer Leistungsversorgung während eines Ruhemodus für die Speicheranordnung haben; und die **gekennzeichnet ist durch**:
wenigstens einen oberen Schalter bzw. Head-Schalter (210), der zwischen die Leistungsversorgung und die Speicheranordnung gekoppelt ist, wobei der wenigstens eine Head-Schalter während des Ruhemodus an- oder abgeschaltet wird abhängig davon, ob Datenspeicherung **durch** die Speicherzellen (152) erwünscht ist oder nicht.

2. Integrierte Schaltung nach Anspruch 1, die weiter Folgendes aufweist:
eine Vielzahl von Vorladungsschaltungen (220) für die Vielzahl von Bitleitungen, wobei die Vorladungsschaltungen während des Ruhemodus abgeschaltet werden.

3. Integrierte Schaltung nach Anspruch 2, die weiter Folgendes aufweist:
eine Steuerschaltung, die konfiguriert ist zum Generieren eines Vorladungssignals für die Vielzahl von Vorladungsschaltungen, wobei die Steuerschaltung über einen unteren Schalter bzw. Foot-Schalter an Schaltungsmasse gekoppelt ist und ein logisches Hoch für das Vorladungssignal während des Ruhemodus vorsieht.

4. Integrierte Schaltung nach Anspruch 1, die weiter Folgendes aufweist:
eine Vielzahl von Transistoren (234a, 234b) zum Koppeln der Vielzahl von Bitleitungen an eine Vielzahl von Abfühlverstärkern (254) für Lesevorgänge, wobei die Vielzahl von Transistoren während des Ruhemodus abgeschaltet wird.

5. Integrierte Schaltung nach Anspruch 4, die weiter Folgendes aufweist:
einen Steuersignalgenerator (160), der konfiguriert ist zum Generieren eines Steuersignals für die Vielzahl von Transistoren, wobei der Steuersignalgenerator an Schaltungsmasse über einen Foot-Schalter (260) gekoppelt ist und und ein logisches Hoch für das Steuersignal während des Ruhemodus vorsieht.

6. Integrierte Schaltung nach Anspruch 1, die weiter Folgendes aufweist:
eine Vielzahl von Treibern zum Treiben der Vielzahl von Bitleitungen für Schreibvorgänge, wobei die Treiber Pull-Up-Transistoren haben, die während des Ruhemodus abgeschaltet werden.

7. Integrierte Schaltung nach Anspruch 6, die weiter Folgendes aufweist:
eine Steuerlogik, die konfiguriert ist zum Generieren von Steuersignalen für die Pull-Up-Transistoren in der Vielzahl von Treibern, wobei die Steuerlogik an Schaltungsmasse über einen Foot-Schalter gekoppelt ist, und ein logisches Hoch für die Steuersignale während des Ruhemodus vorsieht.

8. Integrierte Schaltung nach Anspruch 1, die weiter Folgendes aufweist:
eine Vielzahl von Wortleitungen, die an die Vielzahl von Speicherzellen gekoppelt sind, wobei die Wortleitungen konfiguriert sind zum Trennen der Speicherzellen von der Vielzahl von Bitleitungen während des Ruhemodus.

9. Integrierte Schaltung nach Anspruch 8, die weiter Folgendes aufweist:
eine Treiberschaltung, die konfiguriert ist zum Setzen der Vielzahl von Wortleitungen auf einen vorbestimmten Logikpegel während des Ruhemodus, um die Speicherzellen von der Vielzahl von Bitleitungen zu trennen.

10. Integrierte Schaltung nach Anspruch 1, die weiter Folgendes aufweist:
eine Vielzahl von Transistoren, die zwischen die Leistungsversorgung und die Vielzahl von Bitleitungen gekoppelt sind, wobei die Transistoren während des Ruhemodus abgeschaltet werden, um die Bitleitungen von der Leistungsversorgung zu trennen.

11. Integrierte Schaltung nach Anspruch 10, wobei die Vielzahl von Transistoren mit längeren Längen als Transistoren in den Speicherzellen implementiert wird, um Leckstrom zu verringern, wenn sie während des Ruhemodus abgeschaltet werden.

12. Ein Verfahren, das Folgendes aufweist:
Lesen von Daten aus einer Vielzahl von Spalten der Speicherzellen über eine Vielzahl von Bitleitungen während eines funktionalen Modus;
Schreiben von Daten auf die Vielzahl von Spalten von Speicherzellen über die Vielzahl von Bitleitungen während des funktionalen Modus; und das **gekennzeichnet ist durch**:
Trennen der Vielzahl von Bitleitungen von einer Leistungsversorgung während eines Ruhemodus **durch** Anschalten oder Abschalten wenigstens eines oberen Schalters bzw. Head-Schalters, der zwischen die Leistungsversorgung und die Speicherzellen gekoppelt ist, und zwar während des Ruhemodus, wobei das Anschalten oder Abschalten davon abhängt, ob eine Datenspeicherung **durch** die Speicherzellen erwünscht ist oder nicht.

13. Verfahren nach Anspruch 12, wobei das Trennen der Vielzahl von Bitleitungen Folgendes aufweist:
Abschalten einer Vielzahl von Vorladungsschaltungen für die Vielzahl von Bitleitungen während des Ruhemodus; oder
Abschalten einer Vielzahl von Transistoren, die verwendet werden um die Vielzahl von Bitleitungen an eine Vielzahl von Abfühlverstärkern für Lesevorgänge zu koppeln, und zwar während des Ruhemodus; oder
Abschalten von Pull-Up-Transistoren in einer Vielzahl von Treibern, die verwendet werden, um die Vielzahl von Bitleitungen für Schreibvorgänge zu treiben, und zwar während des Ruhemodus.

## Revendications

1. Un circuit intégré comprenant:
une matrice de mémoire (150) comprenant une pluralité de lignes et une pluralité de colonnes de cellules de mémoire (152) ;
une pluralité de lignes de bits couplées à la pluralité de colonnes de cellules de mémoire, les lignes de bits présentant des chemins de déconnexion à une source d'alimentation pendant un mode de veille de la matrice de mémoire, et **caractérisé par**:
au moins un commutateur de tête *(head switch)* (210) couplé entre l'alimentation et la matrice de mémoire, ledit au moins un commutateur de tête, au cours du mode veille, étant activé ou désactivé en fonction de si la rétention de données par les cellules de mémoire (152) est souhaitée ou pas.

2. Circuit intégré selon la revendication 1, comprenant en outre:
une pluralité de circuits de précharge (220) pour la pluralité de lignes de bits, les circuits de précharge étant désactivés au cours du mode veille.

3. Circuit intégré selon la revendication 2, comprenant en outre:
un circuit de commande configuré pour générer un signal de précharge pour la pluralité de circuits de précharge, le circuit de cpmmande étant couplé à la masse du circuit par l'intermédiaire d'un commutateur de pied *(foot switch)* et assurant la présence d'un niveau logique haut pour le signal de pré-charge au cours du mode veille.

4. Circuit intégré selon la revendication 1, comprenant en outre :
une pluralité de transistors (234a, 234b) pour coupler la pluralité de lignes de bits à une pluralité d'amplificateurs de lecture (254) pour les opérations de lecture, la pluralité de transistors étant désactivés au cours du mode veille.

5. Circuit intégré selon la revendication 4, comprenant en outre:
un générateur de signal de commande (160) configuré pour générer un signal de commande pour la pluralité de transistors, le générateur de signal de commande étant couplé à la masse du circuit par l'intermédiaire d'un commutateur de pied (260) et assurant la présence d'un niveau logique haut pour le signal de commande au cours du mode veille.

6. Circuit intégré selon la revendication 1, comprenant en outre:
une pluralité de circuits d'attaque pour piloter la pluralité de lignes de bits pour des opérations d'écriture, les circuits d'attaque ayant des transistors de forçage au niveau logique haut qui sont bloqués au cours du mode veille.

7. Circuit intégré selon la revendication 6, comprenant en outre:
une logique de commande configurée pour générer des signaux de commande pour les transistors de forçage au niveau logique haut dans la pluralité de circuits d'attaque, la logique de commande étant couplée à la masse du circuit par l'intermédiaire d'un commutateur de pied et assurant la présence d'un niveau logique haut pour les signaux de commande au cours du mode veille.

8. Circuit intégré selon la revendication 1, comprenant en outre:
une pluralité de lignes de mots couplées à la pluralité de lignes de cellules de mémoire, les lignes de mots étant configurées pour déconnecter les cellules de mémoire de la pluralité de lignes de bits au cours du mode veille.

9. Circuit intégré selon la revendication 8, comprenant en outre:
un circuit d'attaque configuré pour régler la pluralité de lignes de mots à un niveau logique prédéterminé au cours du mode veille pour déconnecter les cellules de mémoire de la pluralité de lignes de bits.

10. Circuit intégré selon la revendication 1, comprenant en outre:
une pluralité de transistors couplés entre l'alimentation et la pluralité de lignes de bits, les transistors étant bloqués au cours du mode veille afin de déconnecter les lignes de bits de la source d'alimentation.

11. Circuit intégré selon la revendication 10, dans lequel la pluralité de transistors sont mis en oeuvre avec des longueurs plus longues que les transistors des cellules de mémoire pour réduire le courant de fuite lorsqu'ils sont désactivés au cours du mode veille.

12. Procédé comprenant :
la lecture de données à partir d'une pluralité de colonnes de cellules de mémoire via une pluralité de lignes de bits au cours d'un mode fonctionnel ;
l'écriture de données à la pluralité de colonnes de cellules de mémoire par l'intermédiaire de la pluralité de lignes de bits au cours du mode fonctionnel ; et **caractérisé par** :
la déconnexion de la pluralité de lignes de bits d'une source d'alimentation au cours d'un mode veille en activant ou en désactivant au moins un commutateur de tête qui est couplé entre la source d'alimentation et les cellules mémoire au cours du mode veille, dans lequel l'activation ou le blocage est fonction de si la rétention des données par les cellules mémoire est souhaitée, ou pas.

13. Procédé selon la revendication 12, dans lequel la déconnexion de la pluralité de lignes de bits comprend :
le blocage d'une pluralité de circuits de précharge pour la pluralité de lignes de bits au cours du mode veille, ou
le blocage d'une pluralité de transistors utilisés pour coupler la pluralité de lignes de bits à une pluralité d'amplificateurs de lecture pour les opérations de lecture, au cours du mode veille ; ou
le blocage des transistors de forçage au niveau logique haut dans une pluralité de circuits d'attaque, utilisés pour piloter la pluralité de lignes de bits pour les opérations d'écriture, au cours du mode veille.
